# EUROPEAN PATENT SPECIFICATION

(11) **EP 3 764 107 B1**
(45) Date of publication and mention of the grant of the patent: **09.03.2022**
(21) Application number: 19186170.7
(22) Date of filing: 12.07.2019
(51) Int. Cl.: G01R 15/20, G01R 19/10, G01R 15/18, G01R 19/20, H01F 38/28, H01F 27/02, H01F 27/06, H01F 38/30

(54) **CURRENT TRANSDUCER FOR MEASURING RESIDUAL CURRENTS**
STROMWANDLER ZUR MESSUNG VON RESTSTRÖMEN
TRANSDUCTEUR DE COURANT POUR MESURER DES COURANTS RÉSIDUELS

(43) Date of publication of application: 13.01.2021
(73) Proprietor: LEM International SA, 1228 Plan-les-Ouates (CH)
(72) Inventor: MOUCHET, Steve, 74370 PRINGY (FR)
(74) Representative: reuteler & cie SA

(56) References cited:
- EP-A1- 2 423 693
- EP-A1- 2 924 451
- EP-A1- 3 312 618
- EP-A2- 0 803 732
- DE-A1-102015 205 632
- US-A1- 2010 090 678

## Description

The present invention relates to an electric current transducer arrangement with a pair of primary conductors for measuring differential electrical current flowing in the primary conductors extending through a passage surrounded by a magnetic core of the transducer.

Electrical current transducer modules for current sensing applications typically comprise a magnetic core made of a high permeability magnetic material, surrounding an aperture through which passes a primary conductor carrying the current to be measured. The magnetic core may typically have a generally rectangular or circular shape and either be provided with an air-gap in which a magnetic field detector, such as a Hall effect sensor in the form of an ASIC, is positioned, or a pick-up coil wound around the magnetic core. The magnetic flux generated by the electrical current flowing in the primary conductor and concentrated by the magnetic core is representative of the primary current.

Electrical current sensors are used in a large variety of applications for monitoring or controlling electrical devices and system and in many applications there is an important advantage in reducing the manufacturing cost of such components and also the costs of implementing and using the components in an electrical circuit. There is often also an important advantage in providing compact components in order to miniaturize and/or reduce the weight of the devices in which the components are mounted.

In many applications current transducers are used for measuring a differential current between two conductors, for instance between a pair of conductors of a circuit (supply and return lines).

The voltage difference between the conductors requires good insulation between the pair of conductors. For accurate differential measurement it is also important to ensure accurate positioning of the primary conductor bars extending through the aperture of the magnetic core, due to the effects of the dipole created by the current flowing in the primary conductors.

EP 2 423 693 A1 and EP 2 924 451 A1 each disclose an electric current transducer according to the preamble of claim 1.

It is an object of this invention to provide a current transducer arrangement for measuring a differential current in a pair of primary conductors that is accurate and reliable.

It is advantageous to provide a current transducer that enables easy coupling to conductors of an electrical system yet ensures good insulation between conductors.

It is advantageous to provide a current transducer that measures a differential current and that is easy to install and that is economical to produce.

It is advantageous to provide a current transducer with integrated primary conductors that is robust yet compact.

Objects of the invention have been achieved by providing a current transducer according to claim 1.

Disclosed herein is an electric current transducer comprising a current transducer unit having a housing, a magnetic field detector mounted within the housing, first and second primary conductors, and a central passage extending through the housing and magnetic field detector for receiving first and second primary conductors therethrough carrying primary currents of opposite direction forming a residual current to be measured, the electric current transducer further comprising a primary conductor device comprising an insulating support, the first and second primary conductors being mounted to the insulating support, the first and second primary conductor being formed from cylindrical conducting wires having connection portions for connection to an external circuit and measurement portions extending through the central passage, characterized in that each measurement portion comprise a flattened shape offset from a center axis of the cylindrical conducting wire towards a center of the central passage, the measurement portion of the first primary conductor being separated from the measurement portion of the second primary conductor by a separating wall of the insulating support.

In an advantageous embodiment, the measurement portion comprises a substantially rectangular or oval cross-sectional profile.

In an embodiment, a thickness of the measurement portion is between 20% and 60% of a diameter of the cylindrical conducting wire from which the primary conductor. In a preferred embodiment, the thickness of the measurement portion is between 25% and 50% of the diameter of the cylindrical conducting wire from which the primary conductor is formed.

In an advantageous embodiment, the insulating support comprises an insulating center support including a first conductor support channel receiving a measurement portion of said first conductor and a second conductor support channel receiving a measurement portion of said second conductor, separated by said separating wall, the insulating center support further comprising an outer wall extending from the separating wall, the outer wall engaging in a tight fit a wall of the housing defining the central passage for centering the insulating support with respect to the central passage.

In an advantageous embodiment, the separating wall is planar.

In an advantageous embodiment, the outer wall of the insulating center support comprises a slot having a width allowing slidable insertion of the cylindrical wire forming the primary conductors therethrough, and wherein the slot has a width less than a width of the flattened measurement portion.

In an advantageous embodiment, the connection portions of the primary conductors extend orthogonally with respect to the measurement portions and are connected to the measurement portions via first and second bend portions.

In an advantageous embodiment, the insulating support further comprises an insulating terminal support comprising a base and terminal guide channel portions having passages for positioning and guiding the connection portions received therethrough.

In an advantageous embodiment, the insulating terminal support is a part separately formed from the transducer housing and the insulating center support and is assembled to the housing and the insulating center support.

In an advantageous embodiment, the magnetic field detector comprises a ringshaped fluxgate detector surrounding the central passage.

In an advantageous embodiment, the current transducer further comprises a signal processing circuit comprising a circuit board to which coils of the magnetic field detector are connected and to which connection terminals for current supply to the current transducer and for output of a measurement signal from the current transducer are formed.

In an advantageous embodiment, the connection terminals are connected to a signal processing circuit of the current transducer and connection portions of the primary conductors extend beyond a mounting face of the current transducer housing configured for connection to an external circuit board.

Further objects and advantageous features of the invention will be apparent from the claims, from the detailed description, and annexed drawings, in which:

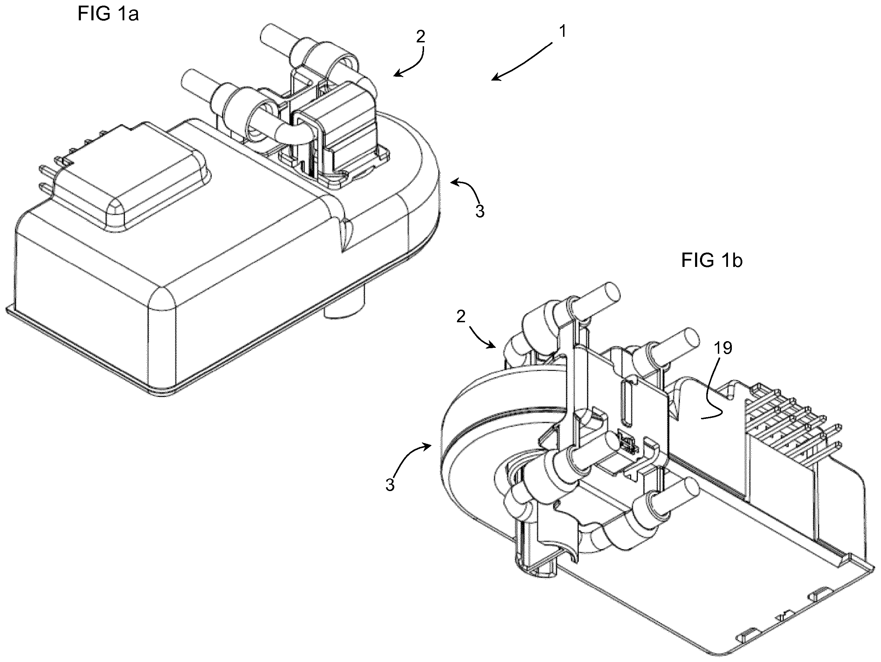

Figures 1a and 1b are perspective views of a current transducer according to an embodiment of the invention;

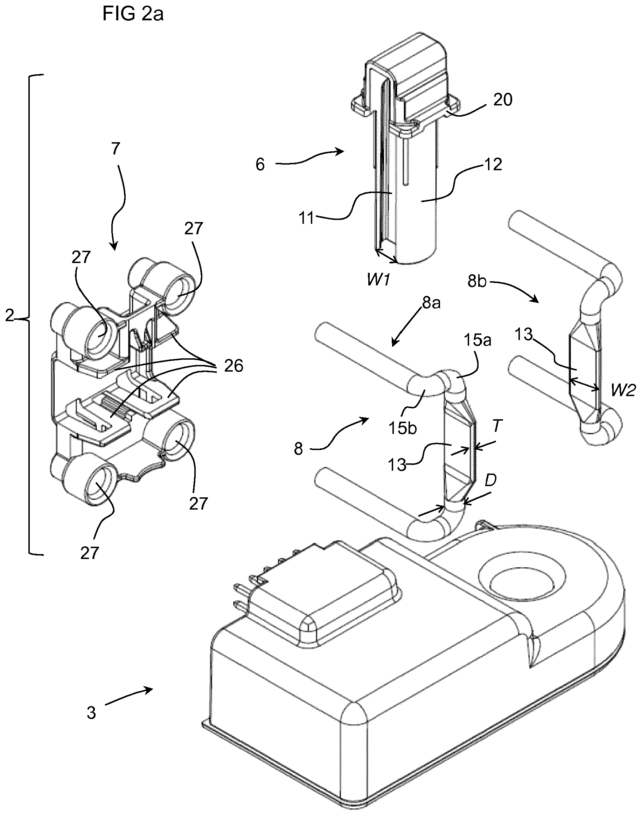

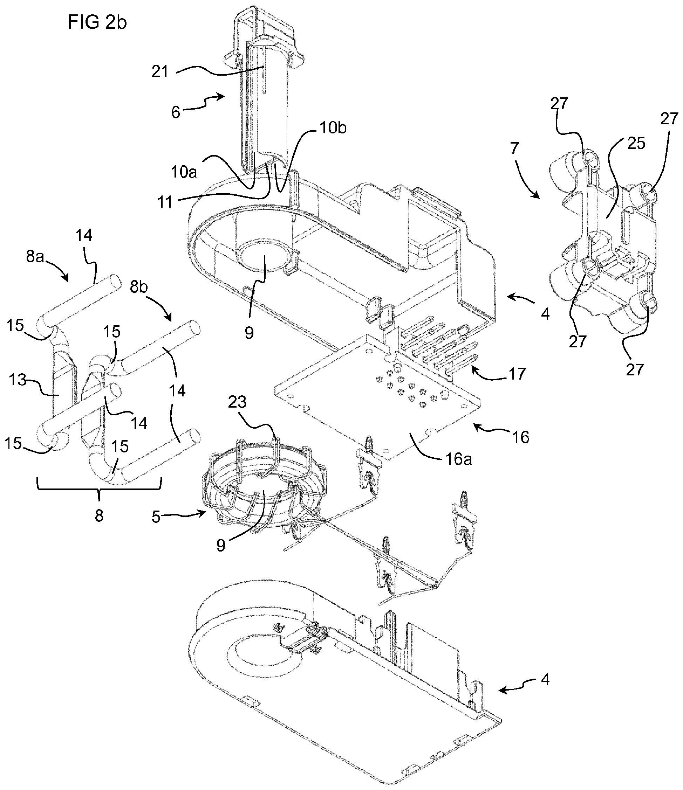

Figures 2a and 2b are exploded perspective views of a current transducer according to an embodiment of the invention;

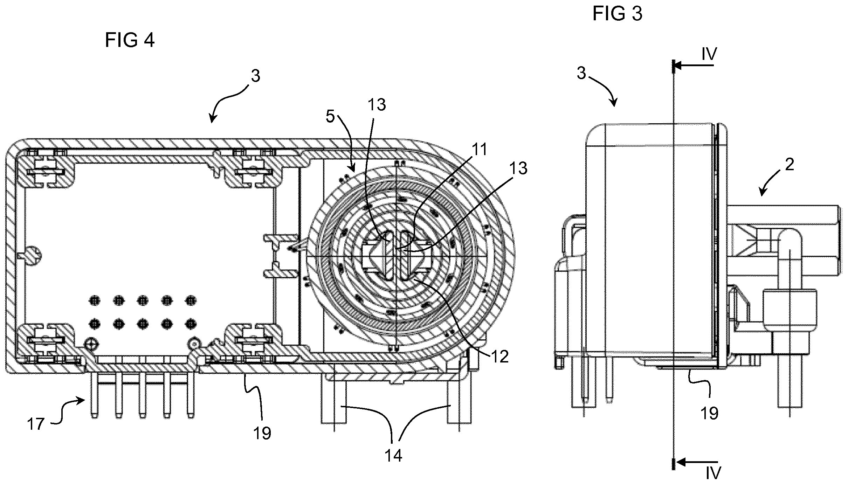

Figure 3 is a side view of a current transducer according to an embodiment of the invention;
Figure 4 is a cross-sectional view through line IV-IV of figure 3.

Referring to the figures, an electrical current transducer 1 according to an embodiment of the invention comprises a current transducer unit 3 and a primary conductor device 2. The current transducer unit 3 comprises a housing 4, a magnetic field detector 5 mounted in the housing, a signal processing circuit 16 including a circuit board 16a mounted in the housing, and connection terminals 17 connected to the signal processing circuit for connection to an external circuit for power supply to the current transducer and for receiving the output measurement signals from the current transducer.

The electrical current transducer 1 in the illustrated embodiment is configured for mounting on an external circuit board (not shown), the housing 4 having a mounting face 19 for mounting against the external circuit board.

The magnetic field detector 5 in the illustrated embodiment is in the form of a ring shaped fluxgate detector that surrounds a central passage 9 through which primary conductors may extend. Fluxgate detectors are *per se* well known and do not need to be further described herein. Within the scope of the invention, it is possible to use other ring shaped magnetic field detectors, for instance comprising a magnetic core having an air-gap in which a magnetic field detector, such as a Hall effect detector is placed. Such magnetic field detectors are also *per se* well known and therefore do not need to be described in more detail herein. In the present invention, the use of a fluxgate magnetic field detector is preferred in view of the small residual currents to be measured and the high sensitivity of the fluxgate type of magnetic field detectors.

The coils 23 of the fluxgate magnetic field detector are connected to the circuit board 16a of the signal processing circuit 16. The connection terminals 17 are also connected to the signal processing circuit, whereby the connection terminals comprise terminals for power supply to the current transducer and terminals for output of the measurement signal. The connection terminals may advantageously be in the form of pin terminals or surface mount terminals that extend beyond the mounting face 19 for connection to an external circuit board (not shown) to which the transducer is intended to be mounted.

The primary conductor device 2 comprises primary conductors 8 that carry the currents (hereinafter referred to as the primary currents) constituting the residual (i.e. differential) current to be measured, and an insulating support comprising an insulating center support 6 and an insulating terminal support 7. The insulating support guides, positions and holds the primary conductors 8 with respect to the central passage 9 and the mounting face 19 of the housing such that the measurement portion of the primary conductors are accurately positioned within the central passage 9 and the connection portions 14 of the primary conductors are accurately positioned with respect to the mounting face 19 for connection to an external circuit board (not shown).

The measurement portions 13 of the primary conductors are positioned, guided and held within an insulating center support 6 and the connection portions of the primary conductors are positioned, guided and held by the insulating terminal support 7 that is assembled to the housing 4 of the current transducer unit and insulating center support 6 after assembly of the primary conductors 8 and insulating center support 6 to the housing 4.

The insulating center support 6 comprises a first conductor support channel 10a and a second conductor support channel 10b separated by a separating wall 11 that forms an insulation barrier between the first and second conductor support channels 10a, 10b. An outer wall 12 connected to the separating wall 11 may be further provided to at least partially surround the respective first and second conductor support channels 10a, 10b. The outer wall 12 may advantageously have a shape that conforms to the shape of the central passage 9, allowing for slidable insertion of the insulating center support 6 in the central passage 9 in a fit with minimal play to ensure accurate positioning of the insulating center support 6 within the central passage 9. An axial flange 20 may be further provided on one axial end of the insulating center support in order to provide a stop that positions the insulating center support 6 with respect to one side of the housing 4 after insertion thereof into the central passage.

Interference ribs 21 extending axially along the outer wall 12 may be provided to engage in interference fit with the wall of the central passage 9, to tightly grip the insulating center support 6 to the housing 4.

The primary conductors 8 comprise a first conductor 8a and a second conductor 8b. The first and se cond conductors are configured for coupling to a supply and return line respectively of an electrical circuit that in normal operation carries a current of the same amplitude but of opposite directions (opposite signs). In the normal operation of the external circuit, the magnetic fields generated by the currents of opposed direction cancel each other out and the residual current to be measured is zero or almost zero (i.e essentially unmeasurable). In case of a leakage current or other fault or situation in which the supply and return currents are not balanced the resulting magnetic field has a certain amplitude measurable by the magnetic field detector 5.

It may be noted however that the invention may be employed to measure residual currents that deviate from an expected or predefined current amplitude that may be a non-zero amplitude.

In order for the residual current measurement to be as accurate as possible, it is important that the magnetic dipole flux generated by the pair of conductors 8a, 8b is minimized and since this flux is approximately proportional to the distance of the primary conductors 8a, 8b, it is therefore advantageous to have the sections of primary conductor extending through the central passage 9 to be as close to each other as possible and as accurately positioned within the centre of the central passage as possible.

It is however advantageous to employ cylindrical shaped wires for the primary conductors due to the ease with which such conductors may be manufactured and formed, in particular for bending the connection portions 14 for connection to an external circuit board or mounting in a connector for connection to an external connector. Cylindrical conductors however are not ideal for achieving the aforementioned objective of reducing the magnetic dipole distance and for positioning close to the centre of the central passage.

Each of the first and second conductors 8a, 8b comprise a measurement portion 13 parallel to the central axis *A*, connected at opposed ends to connection portions 14 via bend portions 15. In the illustrated embodiments, the bend portions 15 comprise essentially two orthogonal bends 15a, 15b that direct the primary conductors away from the central axis A and subsequently orthogonally towards the mounting face 19 such that the connection portions 14 are orthogonal to the measurement portions 13. These bend portions 15a, 15b allow the measurement portions 13 to be positioned close to each other while increasing the distance between the connection portions 14 of respective first and second conductors 8a, 8b in order to increase the electrical creepage distance between the pair of primary conductors that are at a different voltage.

According to an aspect of the invention, the measurement portions 13 of the primary conductors are flattened by a stamping or forging operation that forms the measurement portions 13 into substantially flat or oval bars extending axially through the central passage 9. The substantially flat bars may have an approximately rectangular cross-sectional shape, possibly with rounded edges being a consequence of the flattening process. Other generally flat cross-sectional shapes such as elliptical or generally oval shapes may however represent the flattened forms. In preferred embodiments, the thickness T of the measurement portion is between 30% and 60% of the diameter D of the cylindrical conductor from which the primary conductor is formed. The measurement portions are offset from the centre axes of the cylindrical wires of the primary conductors towards each other such that the measurement portions are arranged close to each other. The flattened bar shapes of the measurement portions 13 can thus be positioned in the respective conductors support channels 10a, 10b against a substantially planar separating wall 11, thus being positioned close to each other and close to the central axis A of the central passage 9.

The flattened measurement portions 13 of the primary conductors are formed prior to insertion of the primary conductors through the central passage 9, the bend portions 15 on one side may also be formed prior to insertion of the primary conductors through the central passage 9, whereby the primary conductors may then be assembled to the insulating center support 6 which is then inserted through the central passage 9. The bend portions on the other side may then be formed and the insulating terminals support 7 may finally be inserted over the connection portions 14 and fixed to the housing by clips, interference fit, welding or other known means.

The measurement portions 13 may be slidably inserted into the respective conductor support channels 10a, 10b of the insulating center support 6. The width *W1* of the slot in the outer wall 12 allows slidable insertion of the cylindrical wire forming the primary conductors therethrough, but may be less than a width *W2* of the flattened measurement portions 13.

The insulating terminals support 7 comprises a base 25 with fixing members 26 for securely fixing to the housing 4 and guide channel portions 27 with passages for insertion of the connection portions 14 therethrough, the insulating terminal support 7 thus accurately securing and positioning the connection portions 14 of the primary conductors 8 for subsequent connection to an external circuit or device.

### List of references used

electric current transducer 1
**primary conductor device 2**
   **insulating center support 6**
      first conductor support channel 10a
      second conductor support channel 10b
      separating wall 11
      outer wall 12
      flange 20
   **insulating terminal support 7**
      base 25
      fixing members 26
      guide channel portions 27
   **primary conductors 8**
      first conductor 8a
      second conductor 8b
         measurement portion 13
         connection portions 14
         bend portion 15
            first and second bends 15a, 15b
**current transducer unit 3**
   housing 4, 4a, 4b
   central passage 9
   magnetic field detector 5
      coils 23
   signal processing circuit 16
      circuit board 16a
   connection terminals 17
   mounting face 19 (for circuit board mounting)

## Claims

1. Electric current transducer comprising a current transducer unit (3) having a housing (4), a magnetic field detector (5) mounted within the housing, first and second primary conductors (8a, 8b), and a central passage (9) extending through the housing and magnetic field detector for receiving said first and second primary conductors (8a, 8b) therethrough carrying primary currents of opposite direction forming a residual current to be measured, the electric current transducer further comprising a primary conductor device (2) comprising an insulating support, the first and second primary conductors (8a, 8b) being mounted to the insulating support, the first and second primary conductor being formed from cylindrical conducting wires having connection portions (14) for connection to an external circuit and measurement portions (13) extending through the central passage (9), **characterized in that** each measurement portion (13) comprise a flattened shape offset from a center axis of the cylindrical conducting wire towards a center of the central passage, the measurement portion (13) of the first primary conductor being separated from the measurement portion (13) of the second primary conductor by a separating wall (11) of the insulating support.

2. Transducer according to the preceding claim, wherein the measurement portion comprises a rectangular or oval cross-sectional profile.

3. Transducer according to any preceding claim, wherein a thickness (T) of the measurement portion is between 25% and 50% of a diameter (D) of the cylindrical conducting wire from which the primary conductor is formed.

4. Transducer according to the preceding claim, wherein the insulating support comprises an insulating center support (6) including a first conductor support channel (10a) receiving a measurement portion (13) of said first conductor (8a) and a second conductor support channel (10b) receiving a measurement portion of said second conductor (8b), separated by said separating wall (11), the insulating center support further comprising an outer wall (12) extending from the separating wall (11), the outer wall engaging in a tight fit a wall of the housing defining the central passage (9) for centering the insulating support with respect to the central passage.

5. Transducer according to any preceding claim, wherein the separating wall (11) is planar.

6. Transducer according to any preceding claim, wherein the outer wall (12) of the insulating center support (6) comprises a slot having a width allowing slidable insertion of the cylindrical wire forming the primary conductors therethrough, and wherein the slot has a width (*W1*) less than a width *(W2)* of the flattened measurement portion (13).

7. Transducer according to any preceding claim, wherein the connection portions (14) of the primary conductors (8) extend orthogonally with respect to the measurement portions (13) and are connected to the measurement portions via first and second bend portions (15a, 15b).

8. Transducer according to any preceding claim, wherein the insulating support further comprises an insulating terminal support (7) comprising a base (25) and terminal guide channel portions (27) having passages for positioning and guiding the connection portions (14) received therethrough.

9. Transducer according to the preceding claim, wherein the insulating terminal support (7) is a part separately formed from the transducer housing (4) and the insulating center support (6) and is assembled to the housing (4) and the insulating center support (6).

10. Transducer according to any preceding claim, wherein the magnetic field detector comprises a ring shaped fluxgate detector surrounding the central passage (9).

11. Transducer according to any preceding claim, wherein the current transducer further comprises a signal processing circuit (16) comprising a circuit board (16a) to which coils of the magnetic field detector (5) are connected and to which connection terminals (17) for current supply to the current transducer and for output of a measurement signal from the current transducer are formed.

12. Transducer according to any preceding claim, wherein the connection terminals (17) are connected to a signal processing circuit (16) of the current transducer (3) and connection portions (14) of the primary conductors (8) extend beyond a mounting face (19) of the current transducer housing (4) configured for connection to an external circuit board.

## Patentansprüche

1. Elektrischer Stromwandler, der eine Stromwandlereinheit (3) mit einem Gehäuse (4), einem Magnetfelddetektor (5), der im Gehäuse montiert ist, einem ersten und einem zweiten primären Leiter (8a, 8b) und einer zentralen Durchführung (9) umfasst, die sich zum Aufnehmen des ersten und des zweiten primären Leiters (8a, 8b), die Primärströme entgegengesetzter Richtung transportieren, die einen zu messenden Reststrom bilden, durch das Gehäuse und den Magnetfelddetektor dadurch erstreckt, wobei der elektrische Stromwandler ferner eine primäre Leitervorrichtung (2) umfasst, die eine Isolierstütze umfasst, wobei der erste und der zweite primäre Leiter (8a, 8b) an der Isolierstütze montiert sind, wobei der erste und der zweite primäre Leiter aus zylindrischen Leitungsdrähten gebildet sind, die Verbindungsabschnitte (14) zur Verbindung mit einer externen Schaltung und Messabschnitte (13), die sich durch die zentrale Durchführung (9) erstrecken, aufweisen, **dadurch gekennzeichnet, dass** jeder Messabschnitt (13) eine abgeflachte Form umfassen, die von einer Mittelachse der zylindrischen Leitungsdrähte zu einer Mitte der zentralen Durchführung versetzt ist, wobei der Messabschnitt (13) des ersten primären Leiters vom Messabschnitt (13) des zweiten primären Leiters durch eine Trennwand (11) der Isolierstütze getrennt ist.

2. Wandler nach dem vorhergehenden Anspruch, wobei der Messabschnitt ein rechteckiges oder ein ovales Querschnittsprofil umfasst.

3. Wandler nach einem der vorhergehenden Ansprüche, wobei eine Dicke (T) des Messabschnitts zwischen 25 % und 50 % eines Durchmessers (D) des zylindrischen Leitungsdrahts, aus dem der primäre Leiter gebildet ist, beträgt.

4. Wandler nach dem vorhergehenden Anspruch, wobei die Isolierstütze eine zentrale Isolierstütze (6) umfasst, die einen ersten Leiterstützkanal (10a) zum Aufnehmen eines Messabschnitts (13) des ersten Leiters (8a) und einen zweiten Leiterstützkanal (10b) zum Aufnehmen eines Messabschnitts des zweiten Leiters (8b), der durch die Trennwand (11) getrennt ist, beinhaltet, wobei die zentrale Isolierstütze ferner eine Außenwand (12) umfasst, die sich von der Trennwand (11) erstreckt, wobei die Außenwand formschlüssig in eine Wand des Gehäuses eingreift und die zentrale Durchführung (9) zum Zentrieren der Isolierstütze mit Bezug auf die zentrale Durchführung definiert.

5. Wandler nach einem der vorhergehenden Ansprüche, wobei die Trennwand (11) planar ist.

6. Wandler nach einem der vorhergehenden Ansprüche, wobei die Außenwand (12) der zentralen Isolierstütze (6) einen Schlitz umfasst, der eine Breite aufweist, der das gleitbare Stecken des zylindrischen Drahts, der die primären Leiter bildet, dadurch erlaubt, und wobei der Schlitz eine Breite (*W1*) aufweist, die kleiner ist als eine Breite *(W2)* des abgeflachten Messabschnitts (13).

7. Wandler nach einem der vorhergehenden Ansprüche, wobei sich die Verbindungsabschnitte (14) der primären Leiter (8) mit Bezug auf die Messabschnitte (13) orthogonal erstrecken und via einen ersten und einen zweiten Bogenabschnitt (15a, 15b) mit den Messabschnitten verbunden sind.

8. Wandler nach einem der vorhergehenden Ansprüche, wobei die Isolierstütze ferner eine Isolierendstütze (7) umfasst, die eine Basis (25) und Führungskanalendabschnitte (27) mit Durchführungen zum Positionieren und Führen der Verbindungsabschnitte (14), die dadurch aufgenommen werden, umfasst.

9. Wandler nach dem vorhergehenden Anspruch, wobei die Isolierendstütze (7) ein Teil ist, das vom Wandlergehäuse (4) und von der zentralen Isolierstütze (6) separat gebildet und am Gehäuse (4) und an der zentralen Isolierstütze (6) angebracht ist.

10. Wandler nach einem der vorhergehenden Ansprüche, wobei der Magnetfelddetektor einen ringförmigen Fluxgatedetektor umfasst, der die zentrale Durchführung (9) umgibt.

11. Wandler nach einem der vorhergehenden Ansprüche, wobei der Stromwandler ferner eine Signalverarbeitungsschaltung (16) umfasst, die eine Leiterplatte (16a) umfasst, mit der Spulen des Magnetfelddetektors (5) verbunden sind und an der Verbindungsanschlüsse (17) zur Stromzuführung zum Stromwandler und zur Ausgabe eines Messsignals vom Stromwandler gebildet sind.

12. Wandler nach einem der vorhergehenden Ansprüche, wobei die Verbindungsanschlüsse (17) mit einer Signalverarbeitungsschaltung (16) des Stromwandlers (3) verbunden sind und sich Verbindungsabschnitte (14) der primären Leiter (8) über eine Montageseite (19) des Stromwandlergehäuses (4) die zur Verbindung mit einer externen Leiterplatte ausgelegt ist, hinaus erstrecken.

## Revendications

1. Transducteur de courant électrique comprenant une unité de transducteur de courant (3) ayant un logement (4), un détecteur de champ magnétique (5) monté à l'intérieur du logement, des premier et deuxième conducteurs primaires (8a, 8b), et un passage central (9) s'étendant à travers le logement et le détecteur de champ magnétique pour recevoir lesdits premier et deuxième conducteurs primaires (8a, 8b) à travers ceux-ci transportant des courants primaires de direction opposée formant un courant résiduel à mesurer, le transducteur de courant électrique comprenant en outre un dispositif de conducteur primaire (2) comprenant un support isolant, les premier et deuxième conducteurs primaires (8a, 8b) étant montés sur le support isolant, les premier et deuxième conducteurs primaires étant formés à partir de fils conducteurs cylindriques ayant des parties de connexion (14) pour la connexion à un circuit externe et des parties de mesure (13) s'étendant à travers le passage central (9), **caractérisé en ce que** chaque partie de mesure (13) comprend une forme aplatie décalée d'un axe central du fil conducteur cylindrique vers un centre du passage central, la partie de mesure (13) du premier conducteur primaire étant séparée de la partie de mesure (13) du deuxième conducteur primaire par une paroi de séparation (11) du support isolant.

2. Transducteur selon la revendication précédente, dans lequel la partie de mesure comprend un profil de section transversale rectangulaire ou ovale.

3. Transducteur selon l'une quelconque des revendications précédentes, dans lequel une épaisseur (T) de la partie de mesure est entre 25 % et 50 % d'un diamètre (D) du fil conducteur cylindrique à partir duquel le conducteur primaire est formé.

4. Transducteur selon la revendication précédente, dans lequel le support isolant comprend un support central isolant (6) comportant un premier canal de support de conducteur (10a) recevant une partie de mesure (13) dudit premier conducteur (8a) et un deuxième canal de support de conducteur (10b) recevant une partie de mesure dudit deuxième conducteur (8b), séparés par ladite paroi de séparation (11), le support central isolant comprenant en outre une paroi extérieure (12) s'étendant à partir de la paroi de séparation (11), la paroi extérieure se mettant en prise, dans un ajustement serré, avec une paroi du logement définissant le passage central (9) pour centrer le support isolant par rapport au passage central.

5. Transducteur selon l'une quelconque des revendications précédentes, dans lequel la paroi de séparation (11) est plane.

6. Transducteur selon l'une quelconque des revendications précédentes, dans lequel la paroi extérieure (12) du support central isolant (6) comprend une fente ayant une largeur permettant l'insertion coulissante du fil cylindrique formant les conducteurs primaires à travers ceux-ci, et dans lequel la fente a une largeur (*W1*) inférieure à une largeur *(W2)* de la partie de mesure (13) aplatie.

7. Transducteur selon l'une quelconque des revendications précédentes, dans lequel les parties de connexion (14) des conducteurs primaires (8) s'étendent orthogonalement par rapport aux parties de mesure (13) et sont connectées aux parties de mesure via des première et deuxième parties coudées (15a, 15b).

8. Transducteur selon l'une quelconque des revendications précédentes, dans lequel le support isolant comprend en outre un support de borne isolant (7) comprenant une base (25) et des parties de canal de guide de borne (27) ayant des passages pour positionner et guider les parties de connexion (14) reçues à travers ceux-ci.

9. Transducteur selon la revendication précédente, dans lequel le support de borne isolant (7) est une pièce formée à partir du logement (4) de transducteur séparément et du support central isolant (6) et est assemblé au logement (4) et au support central isolant (6).

10. Transducteur selon l'une quelconque des revendications précédentes, dans lequel le détecteur de champ magnétique comprend un détecteur à passage de flux de forme annulaire entourant le passage central (9).

11. Transducteur selon l'une quelconque des revendications précédentes, dans lequel le transducteur de courant comprend en outre un circuit de traitement du signal (16) comprenant une carte de circuit (16a) à laquelle sont connectées des bobines du détecteur de champ magnétique (5) et sur laquelle sont formées des bornes de connexion (17) pour l'alimentation en courant du transducteur de courant et pour émettre un signal de mesure à partir du transducteur de courant.

12. Transducteur selon l'une quelconque des revendications précédentes, dans lequel les bornes de connexion (17) sont connectées à un circuit de traitement du signal (16) du transducteur de courant (3), et des parties de connexion (14) des conducteurs primaires (8) s'étendent au-delà d'une face de montage (19) du logement (4) de transducteur de courant configurée pour la connexion à une carte de circuit imprimé externe.
